# EUROPEAN PATENT APPLICATION

(11) **EP 4 768 976 A1**
(43) Date of publication of application: **01.07.2026**
(21) Application number: 25194514.3
(22) Date of filing: 07.08.2025
(51) Int. Cl.: G01R 31/42

(54) **METHOD AND APPARATUS FOR VERIFYING RELIABILITY OF SENSING VALUES FOR FAULT DIAGNOSIS OF GRID-CONNECTED INVERTER**

(30) Priority: 24.12.2024 KR 20240195207
(71) Applicant: Hanwha Solutions Corporation, Jung-gu Seoul 04541 (KR)
(72) Inventor: CHA, Jee Yoon, 04541 Seoul (KR); HYUN, Dong Yub, 04541 Seoul (KR); KIM, Byung Jun, 04541 Seoul (KR)
(74) Representative: Mooser, Sebastian Thomas

(57) **Abstract**

A method of verifying reliability of sensing values may include obtaining inverter voltage sensing values and grid voltage sensing values, calculating voltage sensing value deviations based on differences between the inverter voltage sensing values and the grid voltage sensing values, and determining a voltage sensing value reliability level based on the voltage sensing value deviations and a reliability reference value for voltage sensing values.

## Description

### BACKGROUND

### 1. Field

The present disclosure relates to a method and apparatus for verifying the reliability of sensing values for fault diagnosis of a grid-connected inverter.

### 2. Description of the Related Art

A grid-connected inverter is a device used to efficiently transmit and distribute electrical power via a connection between a power generation facility and a grid, for which stable detection of grid voltage and frequency is essential. Such an inverter needs to operate efficiently while maintaining synchronization with the grid frequency, and to this end, it is important to accurately sense the alternating-current-side voltage and frequency and transmit them to a control system.

In a related-art method of detecting a grid voltage and frequency, even when the grid frequency is within a normal range, a condition where an alternating-current voltage sensing value is abnormal may not be accurately diagnosed, or reliance on a single sensor may affect the stability of the system when the sensor fails.

Accordingly, there is a need for the development of a new method that may increase the stability of a grid-connected inverter and efficiently diagnose a sensor failure.

The above-mentioned background art is technical information possessed by the inventor for the derivation of the present disclosure or acquired during the derivation of the present disclosure, and cannot necessarily be said to be a known technique disclosed to the general public prior to the filing of the present disclosure.

### SUMMARY

Some embodiments of the present disclosure provide a method and apparatus for verifying the reliability of sensing values for fault diagnosis of a grid-connected inverter. Technical objectives of the present disclosure are not limited to the foregoing, and other unmentioned objects or advantages of the present disclosure would be understood from the following description and be more clearly understood from the embodiments of the present disclosure. In addition, it would be appreciated that the objectives and advantages of the present disclosure may be implemented by means provided in the claims and a combination thereof.

As a technical solution for achieving the technical objectives described above, a first aspect of the present disclosure may provide a method of verifying reliability of sensing values, the method including: obtaining inverter voltage sensing values and grid voltage sensing values; calculating voltage sensing value deviations based on differences between the inverter voltage sensing values and the grid voltage sensing values; and determining a voltage sensing value reliability level based on the voltage sensing value deviations and a reliability reference value for voltage sensing values.

According to the first aspect, the method may further include: obtaining inverter frequency sensing values extracted from the inverter voltage sensing values and grid frequency sensing values extracted from the grid voltage sensing values; calculating frequency sensing value deviations based on differences between the inverter frequency sensing values and the grid frequency sensing values; and determining a frequency sensing value reliability level based on the frequency sensing value deviations and a reliability reference value for frequency sensing values.

A second aspect of the present disclosure may provide an apparatus for verifying reliability of sensing values, the apparatus including: a memory storing at least one program; and a processor configured to operate by executing the at least one program, wherein the processor is further configured to obtain inverter voltage sensing values and grid voltage sensing values, calculate voltage sensing value deviations based on differences between the inverter voltage sensing values and the grid voltage sensing values, and determine a voltage sensing value reliability level based on the voltage sensing value deviations and a reliability reference value for voltage sensing values.

According to the second aspect, the processor may be further configured to obtain inverter frequency sensing values extracted from the inverter voltage sensing values and grid frequency sensing values extracted from the grid voltage sensing values, calculate frequency sensing value deviations based on differences between the inverter frequency sensing values and the grid frequency sensing values, and determine a frequency sensing value reliability level based on the frequency sensing value deviations and a reliability reference value for frequency sensing values.

A third aspect of the present disclosure may provide a computer-readable recording medium having recorded thereon a program for causing a computer to execute the method according to the first aspect.

Other aspects, features, and advantages other than those described above will be apparent from the following drawings, claims, and detailed description.

### BRIEF DESCRIPTION OF THE DRAWINGS

The above and other aspects, features, and advantages of certain embodiments of the disclosure will be more apparent from the following description taken in conjunction with the accompanying drawings in which:
FIG. 1 is an exemplary diagram for schematically describing a power supply system;
FIG. 2 is a block diagram for describing a power supply system according to an embodiment of the present disclosure;
FIG. 3 is a block diagram for describing a power supply system according to another embodiment of the present disclosure;
FIG. 4 is a block diagram for describing a power supply system according to another embodiment of the present disclosure;
FIG. 5 is a flowchart for describing an example of a method of verifying the reliability of sensing values for fault diagnosis of a grid-connected inverter, according to an embodiment of the present disclosure;
FIG. 6 is a flowchart for describing an example of a method of calculating an average sensing value deviation within a reliability verification interval, according to an embodiment of the present disclosure;
FIG. 7 is a conceptual diagram for describing an example of a method of determining a reliability level within a reliability verification interval, according to an embodiment of the present disclosure;
FIG. 8 is a flowchart illustrating an example of a method of verifying the reliability of voltage sensing values, according to an embodiment of the present disclosure;
FIG. 9 is a flowchart for describing an example of a method of verifying the reliability of frequency sensing values, according to an embodiment of the present disclosure; and
FIG. 10 is a block diagram for describing an example of an internal configuration of an apparatus for verifying the reliability of sensing values for fault diagnosis of a grid-connected inverter, according to an embodiment of the present disclosure.

### DETAILED DESCRIPTION

Advantages and features of the present disclosure and a method for achieving them will be apparent with reference to embodiments of the present disclosure described below together with the attached drawings. The present disclosure may, however, be embodied in many different forms and should not be construed as being limited to the embodiments set forth herein, and all changes, equivalents, and substitutes that do not depart from the spirit and technical scope of the present disclosure are encompassed in the present disclosure. These embodiments are provided such that the present disclosure will be thorough and complete, and will fully convey the concept of the present disclosure to those of skill in the art. In describing the present disclosure, detailed explanations of the related art are omitted when it is deemed that they may unnecessarily obscure the gist of the present disclosure.

Terms used herein are for describing particular embodiments and are not intended to limit the scope of the present disclosure. Unless otherwise defined, all terms used herein have the same meaning as commonly understood by one of ordinary skill in the art to which the present disclosure belongs.

In the present specification, the singular expression also includes the plural meaning as long as it is not inconsistent with the context. In addition, terms such as "comprises," "includes," or "has" specify the presence of stated features, numbers, stages, operations, components, parts, or a combination thereof, but do not preclude the presence or addition of one or more other features, numbers, stages, operations, components, parts, or a combination thereof.

In addition, although terms such as "first" or "second" may be used herein to describe various elements, these elements should not be limited by these terms. These terms are only used to distinguish one element from another element.

As used herein, phrases such as "in an embodiment", "according to an embodiment", "regarding an embodiment", or "according to an implementation of an embodiment" does not necessarily indicate the same embodiment. In addition, throughout the present specification, the term "embodiment" is an arbitrary distinction used to facilitate description of the present disclosure, and the embodiments are not necessarily mutually exclusive. For example, configurations mentioned herein for describing an embodiment may be applied and/or implemented in other embodiments, and may be applied and/or implemented with modifications without departing from the scope of the present disclosure.

Some embodiments of the present disclosure may be represented by functional block components and various processing operations. Some or all of the functional blocks may be implemented by any number of hardware and/or software elements that perform particular functions. For example, the functional blocks of the present disclosure may be embodied by at least one microprocessor or by circuit components for a certain function.

In addition, for example, the functional blocks of the present disclosure may be implemented by using various programming or scripting languages. The functional blocks may be implemented by using various algorithms executable by one or more processors. In addition, the present disclosure may employ known technologies for electronic settings, signal processing, and/or data processing. Terms such as "mechanism", "element", "unit", or "component" are used in a broad sense and are not limited to mechanical or physical components. In addition, the terms such as "...er", "...or", "... unit", "... module", etc., denote a unit that performs at least one function or operation, which may be implemented as hardware or software or a combination thereof.

In addition, connection lines or connection members between components illustrated in the drawings are merely exemplary of functional connections and/or physical or circuit connections. Various alternative or additional functional connections, physical connections, or circuit connections between components may be present in a practical device.

In addition, the size or thickness of some elements in the drawings may be exaggerated. In addition, elements illustrated in one drawing may not be illustrated in another drawing.

Hereinafter, the present disclosure will be described in detail with reference to the accompanying drawings.

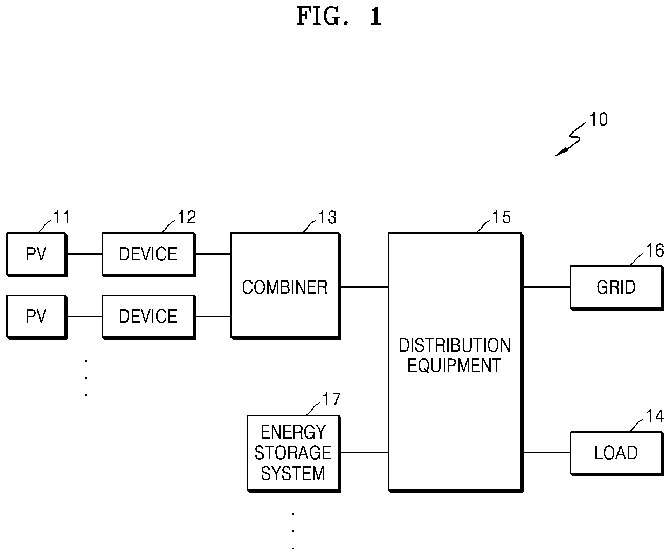

FIG. 1 is an exemplary diagram for schematically describing a power supply system.

Referring to FIG. 1, a power supply system 10 may include a photovoltaic module 11, a device 12, a load 14, and/or distribution equipment 15. The power supply system 10 may be connected to an external grid 16.

At least one photovoltaic module 11 may be installed on a roof or an outer wall of a building to generate power. A plurality of photovoltaic modules 11 may be connected to form a photovoltaic module array.

The photovoltaic module 11 may be connected to the device 12. For example, at least one device 12 may be connected to each photovoltaic module 11. For example, in a case in which one device 12 is connected to each photovoltaic module 11, the number of devices 12 constituting the power supply system 10 may be equal to the number of photovoltaic modules 11.

The device 12 may be a power conditioning system or power conversion system (PCS) that performs power conversion on power generated from the photovoltaic module 11. For example, the device 12 may perform a certain conversion on power generated from the photovoltaic module 11, and then supply the converted power to other components of the power supply system 10 (e.g., the grid 16 and/or the load 14).

In some embodiments, the device 12 may be a module-level power electronics (MLPE) device. For example, the device 12 may be an optimizer or a microinverter (MI).

For example, in a case in which the device 12 is an optimizer, the device 12 may regulate power produced from the photovoltaic module 11 and output the regulated power to an inverter (e.g., a string inverter). A current converted by the inverter (e.g., converted from a direct current to an alternating current) may be output to the grid 16 or the load 14.

As another example, in a case in which the device 12 is an MI, the device 12 may convert power generated from the photovoltaic module 11 (e.g., convert a direct current to an alternating current). A current converted by the device 12 may be output to the grid 16 or the load 14.

Optionally, the power supply system 10 may further include a combiner 13. At least some of the devices 12 may be connected to the distribution equipment 15 through the combiner 13. For example, power output from a plurality of devices 12 may be combined into a single output in the combiner 13 and then supplied to the distribution equipment 15.

In some embodiments, the device 12 and the distribution equipment 15 may be connected to each other through a power path that does not include the combiner 13, and at least one device 12 may be connected to the distribution equipment 15 through a power path that does not include the combiner 13, while at least one other device 12 may be connected to the distribution equipment 15 through the combiner 13.

The combiner 13 may perform control of a voltage, a current, and/or power output from the device 12, according to a power supply state of the photovoltaic module 11, the device 12, and/or the grid 16, and may set the mode of operation of the combiner 13 to a diagnostic mode, an operating mode, or the like.

In some embodiments, the combiner 13 may include an energy management system (EMS) that controls the operation of the combiner 13. The EMS may perform control of a voltage, a current, and/or power supplied to or output from the combiner 13, according to a power supply state of the photovoltaic module 11, the device 12, and/or the grid 16, and may set the mode of operation of the combiner 13 to a diagnostic mode, an operating mode, or the like.

The load 14 refers to an object that is installed at an electricity consumer, such as a house, a commercial facility, or a factory, to operate with at least one of energy generated by the photovoltaic module 11, energy stored in an energy storage system 17, and/or energy supplied from the grid 16. For example, in a case in which the electricity consumer receiving power is a house, the load 14 may include home appliances such as a washing machine, a refrigerator, or a television (TV).

The grid 16 may include an infrastructure system for generating, transmitting, and distributing power. For example, the grid 16 may include an infrastructure system such as a power plant, a substation, or a power line network. In some embodiments, the grid 16 may deliver electrical energy generated in a power plant to the power supply system 10, or deliver surplus power generated in the power supply system 10 to the outside of the power supply system 10.

For example, commercial power transmitted from the grid 16 through utility poles may be supplied to an electricity consumer through a transformer. The power supply system 10 may also be implemented as an off-grid system that is not connected to the grid 16.

In some embodiments, the power supply system 10 may further include at least one energy storage system 17. Optionally, the power supply system 10 may include a plurality of energy storage systems 17. The energy storage system 17 may be supplied with and store power generated by the photovoltaic module 11 and/or power delivered from the grid 16. The energy storage system 17 may efficiently supply power by storing power and then supplying the power to the load 14 when the load 14 needs it.

The energy storage system 17 may include a battery that stores power and a power conversion module. The battery may include a battery management system (BMS) that monitors a state of charge (SoC), a state of health (SoH), a voltage, and/or a current of the battery, performs diagnosis on the battery, and performs safety functions such as current interruption.

In some embodiments, the power conversion module may be a PCS that performs conversion between power of a battery side and power of an opposite side. For example, the PCS may perform conversion between a direct current of a battery side and an alternating current of an opposite side. For example, the PCS may include a bidirectional direct-current (DC)-DC converter connected to the battery to convert a voltage, and a bidirectional inverter that connects the DC-DC converter to an outside of the energy storage system 17.

In some embodiments, the energy storage system 17 may further include an EMS that controls the operation of the energy storage system 17. The EMS may perform control of a voltage, a current, and/or power supplied to or output from the energy storage system 17, according to a power supply state of the battery and/or the grid 16, and may set the mode of operation of the energy storage system 17 to a diagnostic mode, an operating mode, or the like.

Optionally, an EMS coupled to a certain component of the power supply system 10 may control the operation of the predetermined component, may also further control the operation of other components of the power supply system 10. For example, an EMS coupled to the combiner 13 or an EMS coupled to the energy storage system 17 may control both the operation of the combiner 13 and the operation of the energy storage system 17.

In some embodiments, the distribution equipment 15 may provide an electrical connection between components of the power supply system 10, and control a power flow of the power supply system 10. For example, the distribution equipment 15 may electrically connect the photovoltaic module 11 to the load 14. For example, the distribution equipment 15 may be connected to the device 12, which is connected to the photovoltaic module 11, to electrically connect the photovoltaic module 11 to the load 14. Optionally, the distribution equipment 15 may be further connected to at least one of the energy storage system 17 and the grid 16.

For example, the distribution equipment 15 may be a distribution panel that distributes power within the power supply system 10. For example, the distribution equipment 15 may be a master service panel (MSP) that distributes power generated in the photovoltaic module 11 to the load 14 and the like.

As another example, the distribution equipment 15 may be a main controller that performs power distribution within the power supply system and controls each device 12. For example, the main controller may include a switch, a circuit breaker, and a control unit. The switch, the circuit breaker, and the control unit may each be implemented as an independent device, or at least some of the switch, the circuit breaker, and the control unit may be included in a single device.

The main controller may include a switch that controls an electrical connection between components connected to the main controller, such as the device 12 and the load 14. For example, the main controller may include a relay, a power semiconductor, or the like, which provides or blocks an electrical connection to the device 12 and/or the energy storage system 17 according to an operating state of each component of the power supply system 10.

The main controller may perform a rapid shutdown that stops power generation of the photovoltaic module 11 in an emergency situation, such as an occurrence of an overcurrent within the power supply system 10. To this end, the main controller may include a circuit breaker that blocks the connection between the device 12 and the load 14.

The main controller may include a control unit that controls the overall operation of the main controller. The control unit may control the operation of other components of the power supply system 10 (e.g., the device 12 or the energy storage system 17), in addition to the main controller.

The control unit may perform control of a voltage, a current, and/or power output from or supplied to each component, according to a power supply state of the photovoltaic module 11, the device 12, the combiner 13, the load 14, the grid 16, and/or the energy storage system 17. In some embodiments, the control unit may set the mode of operation of the main controller, the device 12, and/or the energy storage system 17 to a diagnostic mode, an operating mode, or the like.

For example, the control unit may control the photovoltaic module 11, the device 12, the combiner 13, and/or the energy storage system 17, based on a state of the power supply system 10. For example, the control unit may control other components (e.g., the device 12) of the power supply system 10 by causing the main controller to perform communication with the other components of the power supply system 10. The communication between the main controller and the other components of the power supply system 10 may be performed by using a power-line communication (PLC) method, but is not limited thereto.

For example, the control unit may control the device 12 according to a power generation state of the photovoltaic module 11. For example, the main controller may receive a control command from a server that monitors the power generation state of the photovoltaic module 11, and the control unit may control the device 12 according to the control command.

When the power supply from the grid 16 is not stable (e.g., in an off-grid situation), the main controller may supply power to at least some of the loads 14. For example, when the power supply from the grid 16 is not stable, the main controller may preferentially supply the power generated from the photovoltaic module 11 and/or the power stored in the energy storage system 17 to a backup load, which has a relatively high need for a stable power supply.

In some embodiments, the power supply system 10 may further include an auxiliary generation device (e.g., a diesel generator) that generates power in a separate manner other than photovoltaic power generation. For example, an auxiliary generation device may be further connected to the distribution equipment 15. When the main controller cannot handle the backup load with only the photovoltaic module 11 and the energy storage system 17 due to environmental factors such as a time of day or weather, the main controller may supply power generated by the auxiliary generation device to the backup load.

The control unit may be implemented by at least one processor. The processor may process instructions of a computer program by performing basic arithmetic, logic, and input/output operations. Here, the instructions may be provided from an internal memory of the main controller, or from an external device. In some embodiments, the processor may control the overall operation of other components included in the main controller.

In some embodiments, the processor may perform at least a part of data analysis, processing, and result information generation for performing the above-described operations, by using at least one of machine learning, a neural network, or a deep learning algorithm, as a rule-based or artificial intelligence algorithm. Examples of the neural network may include neural network models based on architectures such as a convolutional neural network (CNN), a deep neural network (DNN), or a recurrent neural network (RNN).

For example, the processor may be implemented as an array of a plurality of logic gates, or may be implemented as a combination of a general-purpose microprocessor and a memory storing a program executable by the microprocessor. For example, the processor may include a general-purpose processor, a central processing unit (CPU), a microprocessor, a digital signal processor (DSP), a controller, a microcontroller, a state machine, and the like.

In some environments, the processor may include an application-specific integrated circuit (ASIC), a programmable logic device (PLD), a field-programmable gate array (FPGA), and the like. For example, the processor may refer to a combination of processing devices, such as a combination of a DSP and a microprocessor, a combination of a plurality of microprocessors, a combination of one or more microprocessors combined with a DSP core, or a combination of any other such configurations.

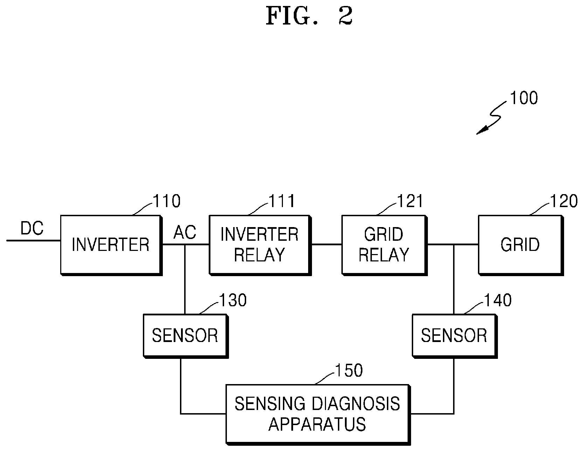

By combining at least some of the above-described components, the power supply system 10 may be implemented in various forms. Hereinafter, various embodiments of the power supply system 10 will be described with reference to FIGS. 2 to 4. However, the implementation of the power supply system 10 is not limited to the embodiments described below.

FIG. 2 is a block diagram for describing a power supply system according to an embodiment of the present disclosure.

Referring to FIG. 2, a power supply system 100 according to an embodiment of the present disclosure may include an inverter 110, an inverter relay 111, a grid 120, a grid relay 121, a first sensor 130, a second sensor 140, and a sensor diagnosis apparatus 150.

In an embodiment, the inverter 110 may convert DC power to alternating current (AC) power. For example, the power converted by the inverter 110 may be output to the grid 120. The present disclosure is not limited to the content illustrated in FIG. 2, and the AC power converted by the inverter 110 may be output to a load or a power consuming device.

In another embodiment, the inverter 110 may convert AC power to DC power. For example, the inverter 110 may convert AC power supplied from the grid 120, to DC power. For example, the DC power converted by the inverter 110 may be output to a battery or an energy storage system.

In an embodiment, the inverter 110 may be implemented as any one of a microgrid, a string inverter, a central inverter, a hybrid inverter, a multi-level inverter, a vehicle inverter, and a smart inverter.

In an embodiment, the grid 120 may receive the AC power converted by the inverter 110. In another embodiment, the grid 120 may transmit AC power to the inverter 110.

In an embodiment, the inverter relay 111 and the grid relay 121 may be arranged between the inverter 110 and the grid 120 to connect or disconnect the inverter 110 to or from the grid 120. For example, when the inverter relay 111 and the grid relay 121 operate in an open state, they may disconnect the inverter 110 from the grid 120, and when they operate in a closed state, they may connect the inverter 110 to the grid 120.

In an embodiment, the first sensor 130 may be connected to one terminal of the inverter 110 to sense a parameter related to an input/output of the inverter 110. For example, the first sensor 130 may be connected to an output terminal of the inverter 110 to sense a parameter related to an output power of the inverter 110. As another example, the first sensor 130 may be connected to an input terminal of the inverter 110 to sense a parameter related to an input power of the inverter 110.

In an embodiment, the first sensor 130 may sense an inverter voltage. For example, the first sensor 130 may sense an AC voltage output by the inverter 110.

In an embodiment, the first sensor 130 may sense an inverter frequency. For example, the first sensor 130 may sense an inverter frequency through a process of sensing an inverter voltage and extracting an inverter frequency from the inverter voltage. Detailed embodiments will be described below.

In an embodiment, the second sensor 140 may be connected to one terminal of the grid 120 to sense a parameter related to an input/output of the grid 120. For example, the second sensor 140 may be connected to an output terminal of the grid 120 to sense a parameter related to an output power of the grid 120. As another example, the second sensor 140 may be connected to an input terminal of the grid 120 to sense a parameter related to an input power of the grid 120.

In an embodiment, the second sensor 140 may sense a grid voltage. For example, the second sensor 140 may sense an AC voltage output by the grid 120.

In an embodiment, the second sensor 140 may sense a grid frequency. For example, the second sensor 140 may sense a grid frequency through a process of sensing a grid voltage and extracting a grid frequency from the grid voltage. Detailed embodiments will be described below.

In an embodiment, the sensor diagnosis apparatus 150 may diagnose a state of the first sensor 130 and the second sensor 140. In other words, the sensor diagnosis apparatus 150 may refer to an apparatus that verifies the reliability of sensing values output by the first sensor 130 and the second sensor 140. Briefly, when sensing values output by the first sensor 130 and the second sensor 140 are within a normal range, the sensor diagnosis apparatus 150 may diagnose that the first sensor 130 and the second sensor 140 are in a normal state. Alternatively, when sensing values output by the first sensor 130 and the second sensor 140 are outside a normal range, the sensor diagnosis apparatus 150 may diagnose that the first sensor 130 and the second sensor 140 are in a fault state. Because the reliability of sensing values, which are used for controlling the power supply system 100 and are output by the first sensor 130 and the second sensor 140, may be guaranteed by the sensor diagnosis apparatus 150, the stability of the power supply system 100 may be improved. Detailed embodiments will be described below.

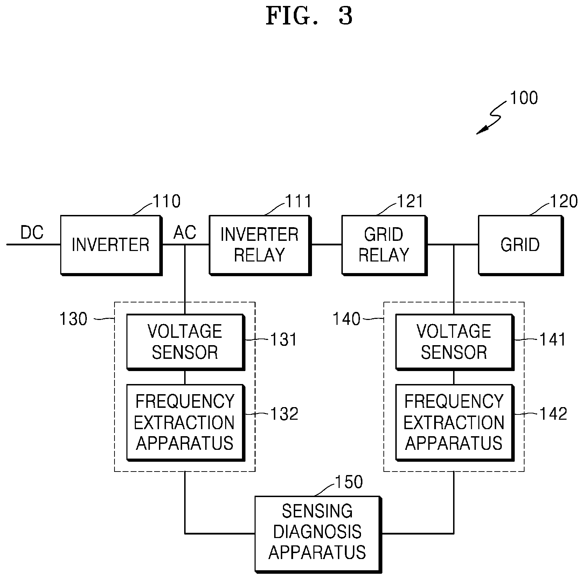

FIG. 3 is a block diagram for describing a power supply system according to another embodiment of the present disclosure.

Referring to FIG. 3, the power supply system 100 according to another embodiment of the present disclosure may include the inverter 110, the inverter relay 111, the grid 120, the grid relay 121, the first sensor 130, the second sensor 140, and the sensor diagnosis apparatus 150. The descriptions provided above with reference to FIG. 2 may be identical to the descriptions of the components of the power supply system 100 illustrated in FIG. 3, and thus, redundant descriptions thereof will be omitted.

In the power supply system 100 illustrated in FIG. 3, the first sensor 130 may include a first voltage sensor 131 and a first frequency extraction apparatus 132, and the second sensor 140 may include a second voltage sensor 141 and a second frequency extraction apparatus 142.

In an embodiment, the first voltage sensor 131 may sense an inverter voltage. For example, the first voltage sensor 131 may sense a voltage of AC power input to the inverter 110 or output by the inverter 110.

In an embodiment, the first frequency extraction apparatus 132 may sense an inverter frequency. For example, the first frequency extraction apparatus 132 may extract an inverter frequency based on an inverter voltage sensed by the first voltage sensor 131.

In an embodiment, the first frequency extraction apparatus 132 may extract an inverter frequency by using a second-order generalized integrator (SOGI) function. For example, the first frequency extraction apparatus 132 may receive an inverter voltage as an input signal and extract a component of an inverter frequency from the inverter voltage.

In another embodiment, the first frequency extraction apparatus 132 may extract an inverter frequency by using an enhanced capture function. For example, the first frequency extraction apparatus 132 may receive an inverter voltage as an input signal and analyze a rising edge and a falling edge of the inverter voltage. The first frequency extraction apparatus 132 may extract an inverter frequency based on a time interval between the rising edge and the falling edge of the inverter voltage.

In yet another embodiment, the first frequency extraction apparatus 132 may extract the inverter frequency by using a phase-locked loop (PLL) function. For example, the first frequency extraction apparatus 132 may receive an inverter voltage as an input signal, measure a phase change of the inverter voltage, and measure a phase difference with respect to an internal reference signal of the first frequency extraction apparatus 132. In some embodiments, the first frequency extraction apparatus 132 may adjust a frequency of a reference signal such that the reference signal is synchronized with an input signal (an inverter voltage), and may extract an inverter frequency based on the frequency-adjusted reference signal.

In an embodiment, the second voltage sensor 141 may sense a grid voltage. For example, the second voltage sensor 141 may sense a voltage of AC power input to the grid 120 or output by the grid 120.

In an embodiment, the second frequency extraction apparatus 142 may sense a grid frequency. For example, the second frequency extraction apparatus 142 may extract a grid frequency based on a grid voltage sensed by the second voltage sensor 141.

In an embodiment, the second frequency extraction apparatus 142 may extract a grid frequency by using a SOGI function. For example, the second frequency extraction apparatus 142 may receive a grid voltage as an input signal and extract a component of a grid frequency from the grid voltage.

In another embodiment, the second frequency extraction apparatus 142 may extract a grid frequency by using an enhanced capture function. For example, the second frequency extraction apparatus 142 may receive a grid voltage as an input signal and analyze a rising edge and a falling edge of the grid voltage. The second frequency extraction apparatus 142 may extract a grid frequency based on a time interval between the rising edge and the falling edge of the grid voltage.

In yet another embodiment, the second frequency extraction apparatus 142 may extract a grid frequency by using a PLL function. For example, the second frequency extraction apparatus 142 may receive a grid voltage as an input signal, measure a phase change of the grid voltage, and measure a phase difference with respect to an internal reference signal of the second frequency extraction apparatus 142. In some embodiments, the second frequency extraction apparatus 142 may adjust a frequency of a reference signal such that the reference signal is synchronized with an input signal (a grid voltage), and may extract a grid frequency based on the frequency-adjusted reference signal.

In an embodiment, the sensor diagnosis apparatus 150 may diagnose a state of the first frequency extraction apparatus 132 and/or the second frequency extraction apparatus 142. Diagnosing a state of each frequency extraction apparatus may be understood as a process of determining whether a frequency sensing value output by the frequency extraction apparatus is within a normal range. For example, the sensor diagnosis apparatus 150 may receive an inverter frequency and a grid frequency from the first frequency extraction apparatus 132 and the second frequency extraction apparatus 142, respectively, and may diagnose the states of the frequency extraction apparatuses based on the inverter frequency and the grid frequency, respectively.

In an embodiment, the sensor diagnosis apparatus 150 may diagnose whether there is an abnormality in frequency sensing, by comparing an inverter frequency output by the first frequency extraction apparatus 132 with a grid frequency output by the second frequency extraction apparatus 142. For example, the sensor diagnosis apparatus 150 may verify the reliability of a frequency sensing value output by the first frequency extraction apparatus 132 and/or the second frequency extraction apparatus 142 by determining whether a difference between the inverter frequency and the grid frequency falls within a normal range. More detailed embodiments will be described below.

In some embodiments, the sensor diagnosis apparatus 150 according to an embodiment of the present disclosure may use both a grid frequency and an inverter frequency to verify the reliability of frequency sensing values in the power supply system 100. That is, the reliability of frequency sensing values may be increased by using a dual-redundancy architecture for verification, rather than relying on a single frequency sensing value.

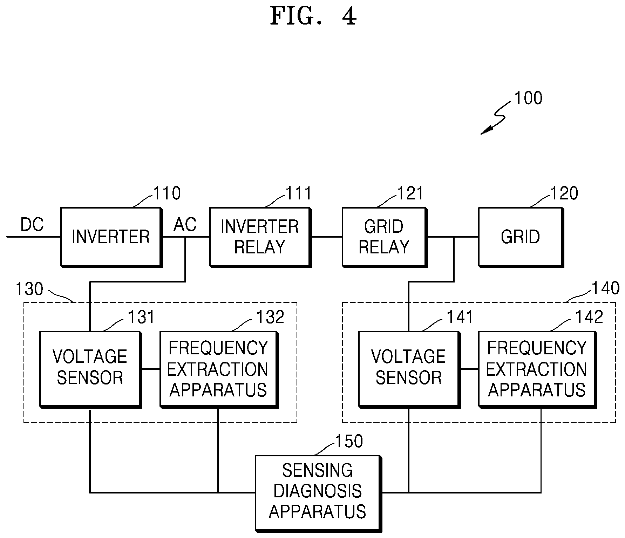

FIG. 4 is a block diagram for describing a power supply system according to another embodiment of the present disclosure.

Referring to FIG. 4, the power supply system 100 according to another embodiment of the present disclosure may include the inverter 110, the inverter relay 111, the grid 120, the grid relay 121, the first sensor 130, the second sensor 140, and the sensor diagnosis apparatus 150. In some embodiments, similar to the power supply system 100 illustrated in FIG. 3, the power supply system 100 illustrated in FIG. 4 may include the first voltage sensor 131, the first frequency extraction apparatus 132, the second voltage sensor 141, and the second frequency extraction apparatus 142. The descriptions provided above with reference to FIGS. 2 and 3 may be identical to the descriptions of the components of the power supply system 100 illustrated in FIG. 4, and thus, redundant descriptions thereof will be omitted.

In an embodiment, the sensor diagnosis apparatus 150 may diagnose states of the voltage sensors 131 and 141 in addition to the frequency extraction apparatuses 132 and 142. That is, the sensor diagnosis apparatus 150 illustrated in FIG. 4 may be connected to one terminal of the inverter 110 and may diagnose a state of the first sensor 130, which includes the first voltage sensor 131 and the first frequency extraction apparatus 132. In some embodiments, the sensor diagnosis apparatus 150 may be connected to one terminal of the grid 120 and may diagnose a state of the second sensor 140, which includes the second voltage sensor 141 and the second frequency extraction apparatus 142. In an embodiment, the sensor diagnosis apparatus 150 may be understood as an apparatus capable of dually diagnosing states of the respective sensors. For example, a process of diagnosing a state of the first voltage sensor 131 may be understood as being analogous to verifying the reliability of an inverter frequency sensing value output by the first frequency extraction apparatus 132, and a process of diagnosing the state of the first frequency extraction apparatus 132 may be understood as being analogous to verifying the reliability of an inverter voltage sensing value output by the first voltage sensor 131. That is, in the embodiment of the power supply system 100 illustrated in FIG. 4, states of the sensors may be diagnosed (or the reliability of sensing values may be verified) through redundancy in voltage and frequency sensing, and thus, the reliability of each sensor and the reliability of the power supply system 100 may be improved.

In some embodiments, in an embodiment, diagnosing, by the sensor diagnosis apparatus 150, a state of each voltage sensor may be understood as a process of determining whether a voltage sensing value output by the voltage sensor falls within a normal range. For example, the sensor diagnosis apparatus 150 may receive an inverter voltage and a grid voltage from the first voltage sensor 131 and the second voltage sensor 141, respectively, and may diagnose states of the respective voltage sensors based on the inverter voltage and the grid voltage.

In an embodiment, the sensor diagnosis apparatus 150 may diagnose whether there is an abnormality in voltage sensing, by comparing an inverter voltage sensing value output by the first voltage sensor 131 with a grid voltage sensing value output by the second voltage sensor 141. For example, the sensor diagnosis apparatus 150 may verify the reliability of a voltage sensing value output by the first voltage sensor 131 and/or the second voltage sensor 141, by determining whether a difference between an inverter voltage sensing value and a grid voltage sensing value falls within a normal range. More detailed embodiments will be described below.

In some embodiments, the sensor diagnosis apparatus 150 according to an embodiment of the present disclosure may use both a grid voltage and an inverter voltage to verify the reliability of voltage sensing values in the power supply system 100. That is, the reliability of voltage sensing values may be increased by using a dual-redundancy architecture for verification, rather than relying on a single voltage sensing value.

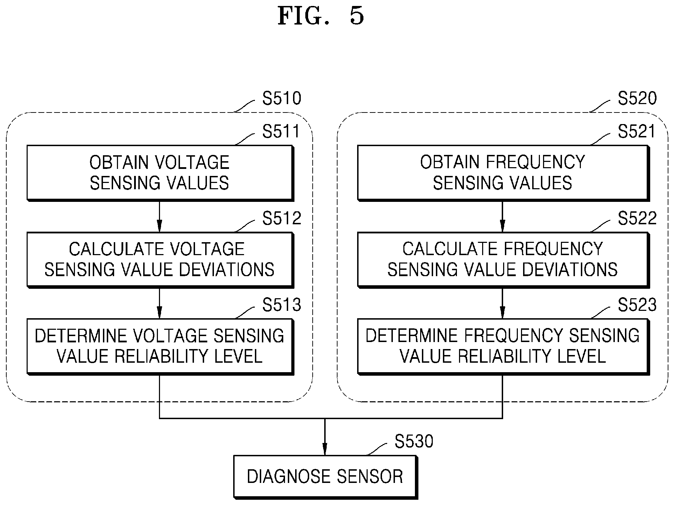

FIG. 5 is a flowchart for describing an example of a method of verifying the reliability of sensing values for fault diagnosis of a grid-connected inverter, according to an embodiment of the present disclosure.

Referring to FIG. 5, an example of the above-described method of verifying the reliability of sensing values may include operations 510 to 530.

In an embodiment, operation 510 may be understood as a process of determining a reliability level of voltage sensing values, and may include operations 511 to 513.

In operation 511, an apparatus for verifying the reliability of sensing values (hereinafter, referred to as the 'apparatus') may obtain voltage sensing values. In an embodiment, the apparatus may obtain inverter voltage sensing values and grid voltage sensing values.

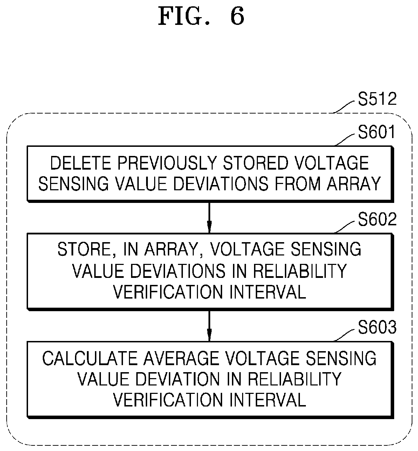

In operation 512, the apparatus may calculate voltage sensing value deviations based on differences between the inverter voltage sensing values and the grid voltage sensing values. In an embodiment, the voltage sensing value deviations may include an average voltage sensing value deviation within a reliability verification interval. A detailed embodiment will be described below with reference to FIG. 6.

In operation 513, the apparatus may determine a voltage sensing value reliability level based on the voltage sensing value deviations and a reliability reference value for voltage sensing values. Here, the reliability level of the voltage sensing values may include at least one of a reliability level for the inverter voltage sensing values and a reliability level for the grid voltage sensing values.

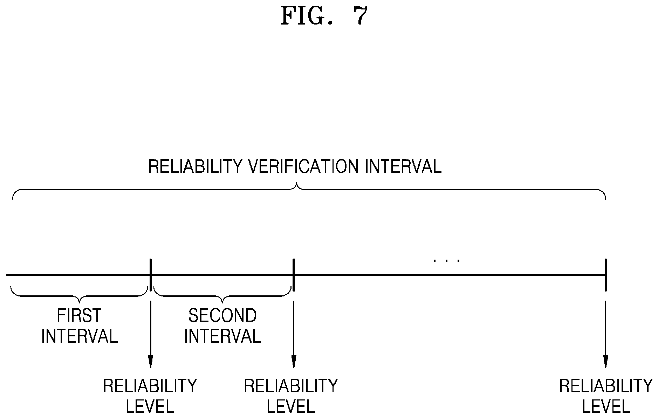

In an embodiment, the reliability reference value for the voltage sensing values may be changed within the reliability verification interval. For example, the apparatus may determine, in a first interval, the voltage sensing value reliability level based on a first reliability reference value, and determine, in a second interval, the voltage sensing value reliability level based on a second reliability reference value, which is different from the first reliability reference value. A detailed embodiment will be described below with reference to FIG. 7.

In an embodiment, the apparatus may determine the voltage sensing value reliability level as any one of a stable level, a warning level, and a fault level, based on the voltage sensing value deviations and the reliability reference value for voltage sensing values. A detailed embodiment will be described below with reference to FIG. 7.

In an embodiment, operation 520 may be understood as a process of determining a reliability level of frequency sensing values, and may include operations 521 to 523.

In operation 521, the apparatus may obtain frequency sensing values. In an embodiment, the apparatus may obtain inverter frequency sensing values and grid frequency sensing values.

In operation 522, the apparatus may calculate frequency sensing value deviations based on differences between the inverter frequency sensing values and the grid frequency sensing values. In an embodiment, the frequency sensing value deviations may include an average frequency sensing value deviation within a reliability verification interval. A detailed embodiment will be described below with reference to FIG. 6.

In operation 523, the apparatus may determine a frequency sensing value reliability level based on the frequency sensing value deviations and a reliability reference value for frequency sensing values. Here, the reliability level of the frequency sensing values may include at least one of a reliability level for the inverter frequency sensing values and a reliability level for the grid frequency sensing values.

In an embodiment, the reliability reference value for the frequency sensing values may be changed within the reliability verification interval. For example, the apparatus may determine, in a first interval, the frequency sensing value reliability level based on a first reliability reference value (meaning a first reliability reference value for frequency sensing values), and determine, in a second interval, the frequency sensing value reliability level based on a second reliability reference value (meaning a second reliability reference value for frequency sensing values), which is different from the first reliability reference value. A detailed embodiment will be described below with reference to FIG. 7.

In an embodiment, the apparatus may determine the frequency sensing value reliability level as any one of a stable level, a suspicious level, a warning level, and a fault level, based on the frequency sensing value deviations and the reliability reference value for frequency sensing values. A detailed embodiment will be described below with reference to FIG. 7.

In operation 530, the apparatus may diagnose a sensor based on the reliability level of the voltage sensing values and the reliability level of the frequency sensing values. In an embodiment, the apparatus may diagnose at least one of a voltage sensor and a frequency sensor that are connected to the inverter, and a voltage sensor and a frequency sensor that are connected to the grid, based on the reliability level of the voltage sensing values and the reliability level of the frequency sensing values.

FIG. 6 is a flowchart for describing an example of a method of calculating an average sensing value deviation within a reliability verification interval, according to an embodiment of the present disclosure.

Referring to FIG. 6, for convenience of description, a process of calculating an average voltage sensing value deviation within a reliability verification interval will be described based on operation 512 of calculating voltage sensing value deviations in FIG. 5. As illustrated in FIG. 6, the process of calculating an average voltage sensing value deviation may include operations 601 to 603, and descriptions to be provided in relation to each operation may be identically applied to a process of calculating an average frequency sensing value deviation.

In operation 601, the apparatus may delete previously stored voltage sensing value deviations from an array.

In an embodiment, the apparatus may store, in the array, voltage sensing value deviations in a reliability verification interval. Operation 601 may be understood as an operation of initializing the array by deleting, from the array, voltage sensing value deviations, which was stored before performing operation 510 or operation 520.

In operation 602, the apparatus may store, in the array, the voltage sensing value deviations in the reliability verification interval.

In an embodiment, the apparatus may calculate the voltage sensing value deviation at every predetermined period in the reliability verification interval. In some embodiments, the apparatus may store, in the array, the voltage sensing value deviations calculated at the predetermined periods. Here, the predetermined period is not limited to a specific value and may be set in advance by a user.

In operation 603, the apparatus may calculate an average voltage sensing value deviation in the reliability verification interval.

In an embodiment, the apparatus may calculate the average voltage sensing value deviation by summing the voltage sensing value deviations stored in the array and dividing the sum by the number of the predetermined periods in the reliability verification interval.

In some embodiments, according to an embodiment in which, based on operations 601 to 603, the average voltage sensing value deviation is calculated and a reliability level of voltage sensing values is determined based on the average voltage sensing value deviation, it is possible to increase the reliability of data by reducing fluctuations in the voltage sensing value that is a subject of comparison with the reliability reference value.

FIG. 7 is a conceptual diagram for describing an example of a method of determining a reliability level within a reliability verification interval, according to an embodiment of the present disclosure.

For convenience of description, a method of determining a reliability level of voltage sensing values in a reliability verification interval will be described with reference to FIG. 7. The descriptions below may be identically applied to a method of determining a reliability level of frequency sensing values in a reliability verification interval.

In an embodiment, the apparatus may determine a reliability level of voltage sensing values, in each interval included in the reliability verification interval.

In an embodiment, the apparatus may determine a reliability level of voltage sensing values in a first interval, based on voltage sensing value deviations in the first interval and a first reliability reference value (termed so for distinction from a reliability reference value in a second interval). In an embodiment, the voltage sensing value deviations in the first interval may refer to a first average voltage sensing value deviation in the first interval (termed so for distinction from an average voltage sensing value deviation in the second interval). For example, the apparatus may calculate the first average voltage sensing value deviation based on deviations between inverter voltage sensing values and grid voltage sensing values in the first interval. In an embodiment, when the first average voltage sensing value deviation is greater than (greater than or equal to) the first reliability reference value, the apparatus may determine the reliability level of the voltage sensing values as a suspicious level. In an embodiment, when the first average voltage sensing value deviation is less than the first reliability reference value, the apparatus may determine the reliability level of the voltage sensing values as a stable level.

In an embodiment, the apparatus may determine the reliability level of voltage sensing values in the second interval, based on voltage sensing value deviations in the second interval and a second reliability reference value. In an embodiment, the voltage sensing value deviations in the second interval may refer to a second average voltage sensing value deviation in the second interval. For example, the apparatus may calculate the second average voltage sensing value deviation based on deviations between inverter voltage sensing values and grid voltage sensing values in the second interval. In an embodiment, when the second average voltage sensing value deviation is greater than (greater than or equal to) the second reliability reference value, the apparatus may determine the reliability level of the voltage sensing values as a warning level. In an embodiment, when the second average voltage sensing value deviation is less than the second reliability reference value, the apparatus may determine the reliability level of the voltage sensing values as a stable level. In an embodiment, the second reliability reference value may be a value less than or equal to the first reliability reference value.

In an embodiment, the apparatus may determine the reliability level of the voltage sensing values as a fault level, based on the number of times the reliability level of a voltage sensing value is determined as a warning level within the reliability verification interval. For example, when the number of times the reliability level is determined as a warning level is greater than or equal to a preset number of times, the apparatus may determine the reliability level of the voltage sensing values as a fault level. In another embodiment, when the number of times the reliability level is determined as a warning level is less than the preset number of times, the apparatus may maintain the reliability level of the voltage sensing values as a warning level.

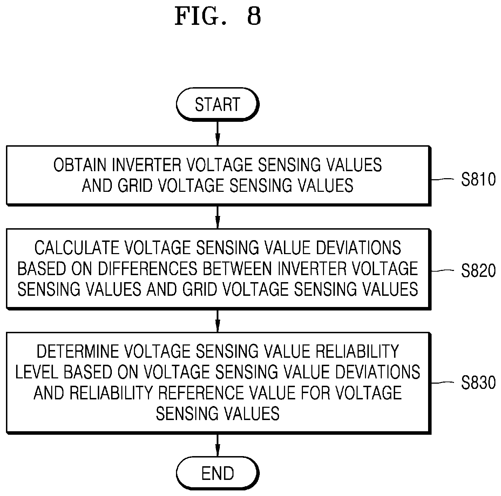

FIG. 8 is a flowchart illustrating an example of a method of verifying the reliability of voltage sensing values, according to an embodiment of the present disclosure.

Referring to FIG. 8, a method of verifying the reliability of voltage sensing values, according to an embodiment, may include operations 810 to 830.

In operation 810, the apparatus may obtain inverter voltage sensing values and grid voltage sensing values.

In operation 820, the apparatus may calculate voltage sensing value deviations based on differences between the inverter voltage sensing values and the grid voltage sensing values.

In an embodiment, the voltage sensing value deviations may include an average voltage sensing value deviation within a reliability verification interval.

In an embodiment, the apparatus may calculate a first average voltage sensing value deviation based on deviations between inverter voltage sensing values and grid voltage sensing values in a first interval included in the reliability verification interval.

In an embodiment, the apparatus may calculate a second average voltage sensing value deviation based on deviations between inverter voltage sensing values and grid voltage sensing values in a second interval after the first interval.

In operation 830, the apparatus may determine a voltage sensing value reliability level based on the voltage sensing value deviations and a reliability reference value for voltage sensing values.

In an embodiment, the apparatus may determine the reliability level of voltage sensing values as a suspicious level, based on the first average voltage sensing value deviation and a first reliability reference value for voltage sensing values.

In an embodiment, the apparatus may determine the voltage sensing value reliability level as any one of a warning level or a stable level, based on the second average voltage sensing value deviation and a second reliability reference value for voltage sensing values, which is less than or equal to the first reliability reference value.

In an embodiment, the apparatus may determine the voltage sensing value reliability level as a fault level, based on the number of times the voltage sensing value reliability level is determined as a warning level within the reliability verification interval.

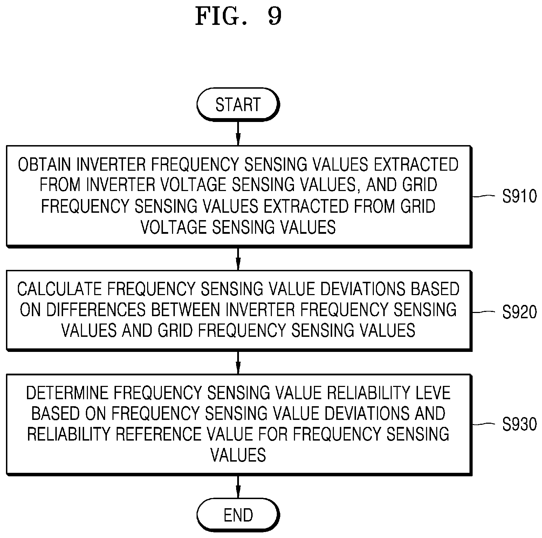

FIG. 9 is a flowchart for describing an example of a method of verifying the reliability of frequency sensing values, according to an embodiment of the present disclosure.

Referring to FIG. 9, a method of verifying the reliability of frequency sensing values, according to an embodiment, may include operations 910 to 930.

In operation 910, the apparatus may obtain inverter frequency sensing values extracted from inverter voltage sensing values, and grid frequency sensing values extracted from grid voltage sensing values.

In operation 920, the apparatus may calculate frequency sensing value deviations based on differences between the inverter frequency sensing values and the grid frequency sensing values.

In an embodiment, the frequency sensing value deviations may include an average frequency sensing value deviation within a reliability verification interval.

In an embodiment, the apparatus may calculate a first average frequency sensing value deviation based on deviations between inverter frequency sensing values and grid frequency sensing values in a first interval included in the reliability verification interval.

In an embodiment, the apparatus may calculate a second average frequency sensing value deviation based on deviations between inverter frequency sensing values and grid frequency sensing values in a second interval after the first interval.

In operation 930, the apparatus may determine a frequency sensing value reliability level based on the frequency sensing value deviations and a reliability reference value for frequency sensing values.

In an embodiment, the apparatus may determine the frequency sensing value reliability level as a suspicious level, based on the first average frequency sensing value deviation and a first reliability reference value for frequency sensing values.

In an embodiment, the apparatus may determine the frequency sensing value reliability level as any one of a warning level or a stable level, based on the second average frequency sensing value deviation and a second reliability reference value for frequency sensing values, which is less than or equal to the first reliability reference value.

In an embodiment, the apparatus may determine the frequency sensing value reliability level as a fault level, based on the number of times the frequency sensing value reliability level is determined as a warning level within the reliability verification interval.

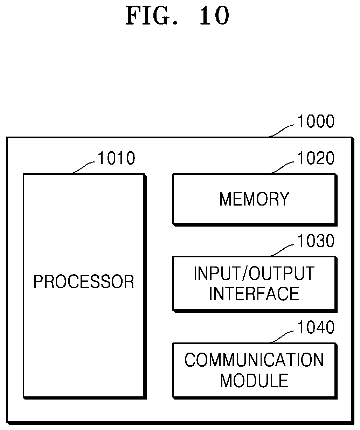

FIG. 10 is a block diagram for describing an example of an internal configuration of an apparatus for verifying the reliability of sensing values for fault diagnosis of a grid-connected inverter, according to an embodiment of the present disclosure.

Referring to FIG. 10, an apparatus 1000 may include a processor 1010, a memory 1020, an input/output interface 1030, and a communication module 1040. For convenience of description, FIG. 10 illustrates only components associated with the present disclosure. Thus, other general-purpose components than those illustrated in FIG. 10 may be further included in the apparatus 1000. In some embodiments, it is obvious to those of skill in the art related to the present disclosure that the processor 1010, the memory 1020, the input/output interface 1030, and the communication module 1040 illustrated in FIG. 10 may also be implemented as independent devices.

The processor 1010 may process commands of a computer program by performing basic arithmetic, logic, and input/output operations. Here, the commands may be provided from the memory 1020 or an external device. In some embodiments, the processor 1010 may control the overall operation of other components included in the apparatus 1000.

For example, the processor 1010 may control at least some of the operations of the sensor diagnosis apparatus 150 described above with reference to FIGS. 2 to 4, or the operations of the apparatus described above with reference to FIGS. 5 to 9.

The processor 1010 may be implemented as an array of a plurality of logic gates, or may be implemented as a combination of a general-purpose microprocessor and a memory storing a program executable by the microprocessor. For example, the processor 1010 may include a general-purpose processor, a CPU, a microprocessor, a DSP, a controller, a microcontroller, a state machine, and the like. In some environments, the processor 1010 may include an ASIC, a PLD, an FPGA, and the like. For example, processor 1010 may refer to a combination of processing devices, such as a combination of a DSP and a microprocessor, a combination of a plurality of microprocessors, a combination of one or more microprocessors combined with a DSP core, or a combination of any other such configurations.

The memory 1020 may include any non-transitory computer-readable recording medium. For example, the memory 1020 may include a permanent mass storage device, such as RAM, ROM, a disk drive, an SSD, or flash memory. As another example, the permanent mass storage device, such as ROM, an SSD, flash memory, or a disk drive, may be a permanent storage device separate from the memory. In some embodiments, the memory 1020 may store an operating system (OS) and at least one piece of program code (e.g., code for the processor 1010 to perform the operations described above with reference to FIGS. 2 to 9).

These software components may be loaded from a computer-readable recording medium separate from the memory 1020. The separate computer-readable recording medium may be a recording medium that may be directly connected to the apparatus 1000, and may include, for example, a computer-readable recording medium, such as a floppy drive, a disk, a tape, a digital video disc (DVD)/compact disc ROM (CD-ROM) drive, or a memory card. Alternatively, the software components may be loaded into the memory 1020 through the communication module 1040 rather than a computer-readable recording medium. For example, at least one program may be loaded into the memory 1020 on the basis of a computer program (e.g., a computer program for the processor 1010 to perform the operations described above with reference to FIGS. 2 to 9) installed by files provided via the communication module 1040 by developers or a file distribution system that distributes installation files of applications.

The input/output interface 1030 may be a unit for an interface with a device (e.g., a keyboard or a mouse) for input or output that may be connected to the apparatus 1000 or included in the apparatus 1000. Although FIG. 10 illustrates that the input/output interface 1030 is an element implemented separately from the processor 1010, the present disclosure is not limited thereto, and the input/output interface 1030 may be implemented to be included in the processor 1010.

The communication module 1040 may provide a configuration or function for the apparatus 1000 and an external device (e.g., an external device 320) to communicate with each other through a network. For example, a control signal, a command, data, and the like provided under control of the processor 1010 may be transmitted to an external device through the communication module 1040 and a network.

According to the above-described solutions of the present disclosure, a state of a sensor may be diagnosed or the reliability of a sensing value may be verified based on the sensing value output by the sensor, thereby improving the reliability of each sensor and the reliability of the power supply system 100.

The effects of the embodiments are not limited to the foregoing, and other effects that are not mentioned herein may be clearly understood by those of skill in the art from the description of the present disclosure.

Meanwhile, an embodiment of the present disclosure may be implemented as a computer program that may be executed through various components on a computer, and such a computer program may be recorded in a computer-readable medium. In this case, the medium may include, but is not limited to, a magnetic medium, such as a hard disk, a floppy disk, or a magnetic tape, an optical recording medium, such as a CD-ROM or a DVD, a magneto-optical medium, such as a floptical disk, and a hardware device specially configured to store and execute program instructions, such as ROM, RAM, or flash memory.

In addition, the computer program may be specially designed and configured for the present disclosure or may be well-known to and usable by those skilled in the art of computer software. Examples of the computer program may include not only machine code, such as code made by a compiler, but also high-level language code that is executable by a computer by using an interpreter or the like.

According to an embodiment, the method according to various embodiments of the present disclosure may be included in a computer program product and provided. The computer program product may be traded as commodities between sellers and buyers. The computer program product may be distributed in the form of a machine-readable storage medium (e.g., a CD-ROM), or may be distributed online (e.g., downloaded or uploaded) through an application store (e.g., Play StoreTM) or directly between two user devices. In a case of online distribution, at least a portion of the computer program product may be temporarily stored in a machine-readable storage medium such as a manufacturer's server, an application store's server, or a memory of a relay server.

The operations of the methods according to the present disclosure may be performed in any suitable order unless otherwise indicated herein or otherwise clearly contradicted by context. The present disclosure is not limited to the described order of the operations. The use of any and all examples, or exemplary language (e.g., 'and the like') provided herein, is intended merely to better illuminate the present disclosure and does not pose a limitation on the scope of the present disclosure unless otherwise claimed. Also, numerous modifications and adaptations will be readily apparent to those skilled in the art without departing from the spirit and scope of the present disclosure.

Therefore, the spirit of the present disclosure should not be limited to the above-described embodiments, and all modifications and variations which may be derived from the meanings, scopes and equivalents of the claims should be construed as falling within the scope of the present disclosure.

## Claims

1. A method of verifying reliability of sensing values, the method comprising:
obtaining inverter voltage sensing values and grid voltage sensing values;
calculating voltage sensing value deviations based on differences between the inverter voltage sensing values and the grid voltage sensing values; and
determining a voltage sensing value reliability level based on the voltage sensing value deviations and a reliability reference value for voltage sensing values.

2. The method of claim 1, wherein the voltage sensing value deviations comprise an average voltage sensing value deviation within a reliability verification interval, and
the calculating of the voltage sensing value deviations comprises calculating a first average voltage sensing value deviation based on deviations between the inverter voltage sensing values and the grid voltage sensing values in a first interval that is included in the reliability verification interval.

3. The method of claim 2, wherein the determining of the voltage sensing value reliability level comprises determining the voltage sensing value reliability level as a suspicious level, based on the first average voltage sensing value deviation and a first reliability reference value for the voltage sensing values.

4. The method of claim 3, further comprising:
calculating a second average voltage sensing value deviation based on deviations between the inverter voltage sensing values and the grid voltage sensing values in a second interval that is subsequent to the first interval; and
determining the voltage sensing value reliability level as any one of a warning level or a stable level, based on the second average voltage sensing value deviation and a second reliability reference value for the voltage sensing values, wherein the second reliability reference value is less than or equal to the first reliability reference value.

5. The method of claim 4, further comprising determining the voltage sensing value reliability level as a fault level, based on a number of times the voltage sensing value reliability level is determined as the warning level within the reliability verification interval.

6. The method of any one of the preceding claims, further comprising:
obtaining inverter frequency sensing values extracted from the inverter voltage sensing values and grid frequency sensing values extracted from the grid voltage sensing values;
calculating frequency sensing value deviations based on differences between the inverter frequency sensing values and the grid frequency sensing values; and
determining a frequency sensing value reliability level based on the frequency sensing value deviations and a reliability reference value for frequency sensing values.

7. The method of claim 6, wherein the frequency sensing value deviations comprise an average frequency sensing value deviation within a reliability verification interval, and
the calculating of the frequency sensing value deviations comprises calculating a first average frequency sensing value deviation based on deviations between the inverter frequency sensing values and the grid frequency sensing values in a first interval that is included in the reliability verification interval.

8. The method of claim 7, wherein the determining of the frequency sensing value reliability level comprises determining the frequency sensing value reliability level as a suspicious level, based on the first average frequency sensing value deviation and a first reliability reference value for the frequency sensing values.

9. The method of claim 8, further comprising:
calculating a second average frequency sensing value deviation based on deviations between the inverter frequency sensing values and the grid frequency sensing values in a second interval that is subsequent to the first interval; and
determining the frequency sensing value reliability level as any one of a warning level or a stable level, based on the second average frequency sensing value deviation and a second reliability reference value for the frequency sensing values, wherein the second reliability reference value is less than or equal to the first reliability reference value.

10. The method of claim 9, further comprising determining the frequency sensing value reliability level as a fault level, based on a number of times the frequency sensing value reliability level is determined as the warning level within the reliability verification interval.

11. An apparatus for verifying reliability of sensing values, the apparatus comprising:
a memory storing at least one program; and
a processor configured to operate by executing the at least one program,
wherein the processor is further configured to obtain inverter voltage sensing values and grid voltage sensing values, calculate voltage sensing value deviations based on differences between the inverter voltage sensing values and the grid voltage sensing values, and determine a voltage sensing value reliability level based on the voltage sensing value deviations and a reliability reference value for voltage sensing values.

12. The apparatus of claim 11, wherein the processor is further configured to obtain inverter frequency sensing values extracted from the inverter voltage sensing values and grid frequency sensing values extracted from the grid voltage sensing values, calculate frequency sensing value deviations based on differences between the inverter frequency sensing values and the grid frequency sensing values, and determine a frequency sensing value reliability level based on the frequency sensing value deviations and a reliability reference value for frequency sensing values.

13. A computer-readable recording medium having recorded thereon a program for causing a computer to execute the method of any one of claims 1 to 10.
